# EUROPEAN PATENT SPECIFICATION

(11) **EP 4 285 437 B1**
(45) Date of publication and mention of the grant of the patent: **25.02.2026**
(21) Application number: 21786571.6
(22) Date of filing: 14.09.2021
(51) Int. Cl.: H01Q 1/24, H01Q 1/38, G01S 3/786, H10K 85/20

(54) **RECTENNA FOR CONVERTING ENERGY**
RECTENNA ZUR UMWANDLUNG VON ENERGIE
RECTENNA POUR CONVERSION D'ÉNERGIE

(30) Priority: 26.01.2021 IT 202100001397
(43) Date of publication of application: 06.12.2023
(73) Proprietor: Quantiqun S.R.L., 24023 Clusone (Bergamo) (IT)
(72) Inventor: GUEDES BRAGUINE, Patricia, 24122 Bergamo (IT)
(74) Representative: Grassi, Stefano
(86) International application number: PCT/IB2021/058339
(87) International publication number: WO 2022/162448

(56) References cited:
- US-A1- 2007 240 757
- US-A1- 2018 302 027
- US-B1- 8 115 683
- P.S. GOH ET AL: "Directional alignment of carbon nanotubes in polymer matrices: Contemporary approaches and future advances", COMPOSITES PART A: APPLIED SCIENCE AND MANUFACTURING, vol. 56, 1 January 2014 (2014-01-01), AMSTERDAM, NL, pages 103 - 126, XP055398523, ISSN: 1359-835X, DOI: 10.1016/j.compositesa.2013.10.001
- YADAV DEEPAK: "Solar Energy Harvesting by Carbon Nanotube Optical Rectenna: A Review", 16 December 2020 (2020-12-16), pages 1 - 5, XP055840579, ISBN: 978-1-7281-8880-5, Retrieved from the Internet <URL:https://ieeexplore.ieee.org/stampPDF/getPDF.jsp?tp=&arnumber=9358863&ref=aHR0cHM6Ly9pZWVleHBsb3JlLmllZWUub3JnL3NlYXJjaC9zZWFyY2hyZXN1bHQuanNwP2FjdGlvbj1zZWFyY2gmbmV3c2VhcmNoPXRydWUmbWF0Y2hCb29sZWFuPXRydWUmcXVlcnlUZXh0PSglMjJBbGwlMjBNZXRhZGF0YSUyMjpyZWN0ZW5uYSklMjBBTkQlMjAoJTIyQWxsJTIwTWV0YWRhdGElMjI> DOI: 10.1109/iSSSC50941.2020.9358863

## Description

The present invention relates to the technical field of devices for generating and managing energy.

In particular, the present invention relates to a rectenna usable for converting the energy transported by an electromagnetic wave into electric energy, in particular into a current signal.

The growing demand for electric energy inevitably clashes with the disadvantages deriving from the negative environmental impact caused by the use of traditional polluting sources.

In this context, a wide range of solutions is known which more or less efficiently allow the generation/conversion of energy from clean sources or with a reduced or no environmental impact.

An interesting example is represented by rectennae, i.e., special antennas which can be used to directly convert the energy carried by electromagnetic waves into direct current.

Example of available device in this technological field may be found for example in the following documents: US2007/240757A1, US8115683B1, US2018/302027A1 and in the scientific papers *"*Directional alignment of carbon nanotubes in polymer matrices: Contemporary approaches and future advances" by P. S. Goh et al. and "Solar Energy Harvesting by Carbon Nanotube Optical Rectenna: A Review" by Yadav Deepak.

Said documents disclose various kind of rectennae produced with carbon nanotubes and implemented in particular as photovoltaic cells components.

However, the Applicant has noted that the currently available technology still has room for improvement, as the efficiency of such a solution is currently structurally limited both in terms of the amount of energy which can be produced and in terms of the range of wavelengths with which the known rectennae are capable of tuning (mainly limited to microwaves and radio waves).

Therefore, there is a strong need to develop new solutions capable of improving the conversion performance of the rectennae.

In this context, the technical task underlying the present invention is to propose a rectenna which obviates at least some of the drawbacks in the prior art as described above.

In particular, an object of the present invention is to provide a rectenna capable of optimising the energy conversion process.

The stated technical task and specified objects are substantially achieved by a rectenna comprising the technical features set forth in one or more of the appended claims.

According to the present invention, a rectenna is shown for converting energy which comprises a support element.

Preferably the support element has a plate-shaped configuration.

The rectenna further comprises a first plurality of electrically conductive nanofibres deposited on the support element.

The first plurality of nanofibres defines a current rectifier of the rectenna. The rectenna further comprises a second plurality of electrically conductive nanofibres deposited on the first plurality of nanofibres.

The second plurality of nanofibres defines an antenna of the rectenna configured to capture an electromagnetic wave.

Advantageously, the use of nanofibres to create the essential components of the rectenna allows to improve the performance thereof thanks to the substantial increase in specific surface area which can interact with the electromagnetic wave to capture it and convert it into an electric current. The dependent claims, incorporated herein by reference, correspond to different embodiments of the invention.

Further features and advantages of the present invention will become more apparent from the following indicative, and hence non-limiting, description of a preferred, but not exclusive, embodiment of a rectenna as illustrated in the appended drawings, in which:

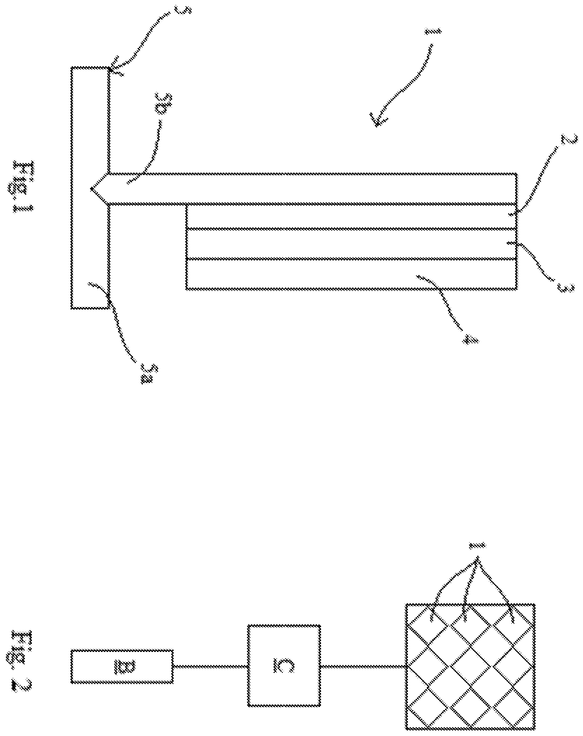

- figure 1 shows a schematic view of the rectenna according to the present invention;
- figure 2 schematically shows a device for converting energy which implements a plurality of rectennae.

In the appended drawings, reference numeral 1 generically indicates a rectenna.

The rectenna 1 is a type of antenna which can be used to convert energy which is transported by an electromagnetic wave (especially microwaves and radio waves) into direct current. Such a conversion is performed by coupling an antenna, in which the received electromagnetic wave generates an alternating current, with a current rectifier which converts the alternating current generated in the antenna into direct current.

In accordance with the present invention, the rectenna 1 comprises a support element 2, a first plurality 3 of nanofibres and a second plurality 4 of nanofibres.

The support element 2 preferably has a plate-shaped conformation, i.e., it defines and provides a plate-shaped surface which has the function of supporting at least some of the other components of the rectenna 1.

The first plurality 3 of nanofibres comprises electrically conductive nanofibres which are deposited on the support element 2 to define a current rectifier of the rectenna 1.

The second plurality 4 of nanofibres also comprises electrically conductive nanofibres which are deposited on the first plurality 3 of nanofibres so as to define an antenna of the rectenna 1 configured to capture an electromagnetic wave.

In other words, the second plurality 4 of nanofibres defines an interface surface capable of receiving an electromagnetic wave, generating an alternating current signal in response which is transmitted to the first plurality 3 of nanofibres which receives it and in turn converts it into a direct current signal which can then be subsequently transmitted (as will be further explained below) and used/stored.

Advantageously, the creation of the components of the rectenna 1 by means of nanofibres allows to significantly increase the specific surface area available and modulate the specific wavelength with which the rectenna 1 can tune, extending the range of wavelengths usable for the conversion/generation of electric energy as a function of the size and/or arrangement of the nanofibres.

In order to produce continuous nanofibres and to deposit them so as to obtain particularly high conversion performance, the first plurality 3 of nanofibres and the second plurality 4 of nanofibres are made by means of an electrospinning process.

Electrospinning is a production process which allows to obtain continuous filaments of synthetic material of an extraordinarily small diameter. Operatively, a polymer jet can be stretched inside a high electric field by means of an electrospinning process.

The nanofibres thus produced can reach much smaller diameters than those obtained using traditional techniques.

In detail, an electrospinning system essentially comprises a die and a manifold.

A reserve of precursor material, melted or in solution, is inserted inside the die, to which an electric field is applied.

Raising the applied electrostatic potential increases the surface charge of the precursor material, until the moment when, thanks to the acquired surface charge, the precursor material in the liquid state manages to overcome the surface tension which influences its shape and assumes the conformation known as the Taylor cone, whose shape depends on the relationship between surface tension and electrostatic repulsion of the molecules present in the precursor material.

Due to the peak effect, a concentration of charges occurs in the tip of the Taylor cone and consequently the precursor material tends to be ejected due to the attraction exerted by the applied electric field which turns out to be much stronger on the tip, where the highest concentration of charges occurs, than on the body of the Taylor cone.

The ejected jet then passes through two phases, a first phase in which, still in the liquid state, it proceeds linearly along the electric field applied in the direction of the manifold, and a second phase in which, passing to the solid state, the charges present in the jet migrate towards the surface of the fibre which has been formed causing, under the effect of the electric field applied, the curvature and a further thinning.

The second phase continues until the nanofibre reaches the manifold where it is finally collected so as to define the first plurality 3 (therefore the rectifier) or the second plurality 4 (therefore the antenna) of nanofibres of the rectenna 1.

In general, i.e., regardless of the production process implemented, the adhesion between the nanofibres is achieved thanks to the presence of a bioadhesive substance applied in concentrations comprised between 7% and 66% weight/weight, comprising at least one of: dextran, cellulose derivatives such as carboxymethylcellulose, hydroxypropylmethylcellulose (HPMC) or polyethylene oxides.

Still in a manner independent of the specific production process implemented, the first plurality 3 of nanofibres and/or the second plurality 4 of nanofibres comprises at least two subsets of nanofibres comprising nanofibres aligned along respective deposition directions, the deposition direction of each subset of nanofibres preferably being inclined with respect to the deposition direction of at least one different subset of nanofibres.

In particular, each plurality 3, 4 of nanofibres comprises two subsets of nanofibres deposited along two deposition directions perpendicular to each other so as to give the rectenna a grid configuration which allows maximising the interaction with the incident electromagnetic wave. Preferably, the support element 2 and/or the first plurality 3 of nanofibres and/or the second plurality 4 of nanofibres are made of at least one material selected from: conductive materials, preferably polycaprolactone (PCL, A-PCL), polyaniline (PANI, PANI-3) and combinations thereof, structurally conductive materials, preferably carbon nanotubes, semiconductor materials, preferably titanium dioxide (TiO₂) and zinc oxide (ZnO) or ferrous oxide and/or boron nitride (h-BN).

In other words, each constituent element of the rectenna 1 can be made independently and autonomously using any of the materials indicated above or a combination thereof.

In accordance with an aspect of the present invention, the first plurality 3 of nanofibres and/or the second plurality 4 of nanofibres has a mesh density which is such as to define a plurality of quantum cavities.

It should be noted that for the purposes of the present description, the term mesh density refers specifically to the density of nanofibres present in the surface of the layer which they compose and consequently the greater the mesh density, the smaller the space between nanofibres or groups of adjacent nanofibres (and therefore the smaller the dimensions of the delimited quantum cavity).

Alternatively or additionally, the rectenna comprises a third plurality of nanofibres (not shown in the appended drawings) which defines a capture layer having a mesh density such as to define a plurality of quantum cavities.

Said third plurality of nanofibres can be made by the same processes (electrospinning in particular) and using the same materials summarised above which allow the production of the first and second 3, 4 plurality of nanofibres.

Regardless of the specific plurality of nanofibres which define them, each quantum cavity is adapted and configured to retain an atom in the fundamental state or a cluster of atoms in the fundamental state. Thereby, the interaction with electromagnetic waves having a specific wavelength can excite the trapped atoms in the respective quantum cavity causing their transition to an excited energy level from which they can subsequently decay, releasing a quantity of energy (by means of the generation of photons or phonons) which can be captured and absorbed by the plurality of nanofibres defining the quantum cavities or by the plurality of adjacent nanofibres which converts it into an electrical current signal which can in turn be sent to users for use or storage.

In accordance with an aspect of the present invention, the rectenna 1 is integrable into a biosensor comprising a plurality of layers of nanofibres appropriately functionalised to define respective components of the rectenna 1 and possibly also components configured for the measurement and/or analysis of one or more biometric parameters.

In this context, the support layer 2 comprises at least one portion made of biocompatible material which allows the application of the rectenna 1 in direct contact with the body of a patient.

Advantageously, the support layer 2 can comprise an adhesive material applied in at least one portion of a face thereof opposite that in which the first plurality 3 of nanofibres is applied.

The presence of the adhesive material allows the device to be constrained in a stable position, keeping it in position during its use, in particular if it is applied in direct contact with the user's body, for example at the mucous membranes of the mouth or vaginal mucosa.

Again in this context, the rectenna 1 can be configured to supply the current signal generated to one or more components of the biosensor to allow the operation thereof.

In accordance with a further aspect, the rectenna 1 further comprises an orientation base 5 coupled to the support element so as to support it.

In particular, the support element 2 is rotatably coupled to the orientation base 5 so as to be able to rotate around a rotation axis lying in the same lying plane of the support element 2 itself.

In accordance with a possible embodiment, the support base comprises a plate-shaped body 5a from which a rotating pin 5b, coupled in turn with the support element 2, extends away therefrom, which is then arranged perpendicularly to the plate-shaped body 5a.

As will be explained below, thanks to the presence of the orientation base 5 the rectenna is adjustable in a plurality of directions so as to optimise its tuning with an electromagnetic wave.

Advantageously, the present invention achieves the proposed objects, overcoming the drawbacks complained of in the prior art by providing the user with a more versatile rectenna capable of converting more energy than the devices of known type thanks in particular to the greater specific surface which can interact with the electromagnetic wave.

A device 10 for converting energy is further part of the present invention. In particular, the device 10 is configured to convert the energy carried by an electromagnetic wave into direct current which can be used or stored. Structurally, the device comprises at least one rectenna 1 which has one or more of the features described above.

In particular, the at least one rectenna 1 used inside the device 10 comprises the orientation base 5.

The device 10 further comprises movement means associated with said at least one rectenna 1 and configured to rotate the support element 2, modifying the orientation of the first and the second plurality 3, 4 of nanofibres.

In particular, the movement means can comprise piezoelectric actuators or any other component capable of promoting the rapid and precise rotation of the support element 2 with respect to the orientation base 5 thereof. The device 10 further comprises a control unit C configured to measure a current signal generated by said at least one rectenna 1 and to activate the movement means as a function of said current signal.

Operatively, the control unit measures the intensity of the current signal generated by the rectenna 1 when the latter receives an electromagnetic wave and activates the movement means to change the orientation of the rectenna 1 until the current signal generated is maximised.

In particular, the control unit C is configured to activate the movement means so as to tune the at least one rectenna 1 with a specific electromagnetic wave.

In other words, the control unit C determines the orientation of the at least one rectenna so that the latter is tuned with a specific electromagnetic wave, maximising the conversion of the energy obtainable from the interaction with said electromagnetic wave.

This is particularly useful if the rectenna 1 is used to capture an electromagnetic wave generated by a source which varies its position over time (for example, a solar radiation).

In fact, in this context, the rectenna 1 is capable of changing its orientation following the movements of the source of the electromagnetic radiation, always keeping the interaction maximised and consequently optimising the conversion process.

In order to further optimise the energy conversion/generation process, the device 10 comprises a plurality of rectennae 1 preferably arranged according to a grid scheme defined so as to minimise possible interference between adjacent rectennae 1.

In this context, the control unit is configured to activate the movement means so as to rotate each rectenna 1 independently and autonomously.

It is thereby possible to tune each rectenna 1 or group of rectennae 1 with respective electromagnetic waves, maximising the overall output which can be generated.

This aspect is particularly relevant if the device 10 comprises a large number of rectennae 1, in which case rectennae 1 arranged in different positions could be capable of optimally capturing electromagnetic waves coming from different directions.

Further, the device 10 can comprise a battery B electrically connected with the at least one rectenna 1 and configured to store electric energy generated by said rectenna 1.

Alternatively or additionally, the device 10 is connected or connectable (directly or via the battery) with a utility which can be powered by the electric energy produced through the at least one rectenna.

## Claims

1. A rectenna for converting energy comprising:
- a plate-shaped support element (2);
- a first plurality (3) of electrically conductive nanofibres deposited on said support element (2) to define a current rectifier of the rectenna;
- a second plurality (4) of electrically conductive nanofibres deposited on the first plurality (3) of nanofibres to define an antenna of the rectenna configured to capture an electromagnetic wave;
and **characterized in that** at least one of the first plurality (3) of nanofibres and the second plurality (4) of nanofibres has a mesh density that is such as to define a first plurality of quantum cavities configured for an interaction with the electromagnetic wave having a specific wavelength.

2. The rectenna according to claim 1, wherein the first plurality (3) of nanofibres and the second plurality (4) of nanofibres are made by an electrospinning process.

3. The rectenna according to claim 1 or 2, wherein the first plurality of nanofibres (3) and/or the second plurality of nanofibres (4) comprises at least two subsets of nanofibres comprising nanofibres aligned along respective deposition directions, the deposition direction of each subset of nanofibres preferably being inclined with respect to the deposition direction of at least one different subset of nanofibres.

4. The rectenna according to any one of the preceding claims, comprising a third plurality of nanofibres, deposited on the second plurality (4) of nanofibres, defining a capture layer having a mesh density that is such as to define a plurality of second quantum cavities configured for an interaction with the electromagnetic wave having a specific wavelength.

5. The rectenna according to any one of the preceding claims, wherein each quantum cavity is adapted to retain an atom in the fundamental state.

6. The rectenna according to any one of the preceding claims, wherein the support element (2) and/or the first plurality (3) of nanofibres and/or the second plurality (4) of nanofibres are made of at least one material selected from: conductive materials, preferably polycaprolactone, PCL, A-PCL, polyaniline, PANI, PANI-3, and combinations thereof, structurally conductive materials, preferably carbon nanotubes, semiconductor materials, preferably titanium dioxide, TiO2, and zinc oxide, ZnO, or ferrous oxide and/or boron nitride, h-BN.

7. The rectenna according to any one of the preceding claims, comprising an orientation base (5), said support element (2) being rotatably coupled with the orientation base (5) to rotate around a rotation axis lying in said plate-shaped support element (2).

8. A device for converting energy comprising:
- at least one rectenna (1) according to claim 7;
- movement means associated with said at least one rectenna (1) and configured to rotate the support element (2) by modifying the orientation of the first and the second plurality (3, 4) of nanofibres;
- a control unit (C) configured to measure a current signal generated by said at least one rectenna (1) and to activate the movement means as a function of said current signal.

9. The device according to claim 8, wherein the control unit (C) is configured to activate the movement means so as to tune the at least one rectenna (1) with an electromagnetic wave.

10. The device according any one of claims 8 to 9, comprising a plurality of rectennas (1).

11. The device according to claim 10, wherein the control unit (C) is configured to activate the movement means so as to rotate each rectenna (1) independently and autonomously.

12. The device according to any one of claims 8 to 11 comprises a battery (B) electrically connected to the least one rectenna (1) and configured to store electric energy converted by said rectenna (1).

## Patentansprüche

1. Eine Rectenna zur Umwandlung von Energie, umfassend:
- ein plattenförmiges Trägerelement (2);
- eine erste Vielzahl (3) elektrisch leitfähiger Nanofasern, die auf dem Trägerelement (2) aufgebracht sind, um einen Stromgleichrichter der Rectenna zu definieren;
- eine zweite Vielzahl (4) elektrisch leitfähiger Nanofasern, die auf der ersten Vielzahl (3) von Nanofasern abgeschieden sind, um eine Antenne der Rectenna zu definieren, die zum Erfassen einer elektromagnetischen Welle konfiguriert ist;
und **dadurch gekennzeichnet, dass** mindestens eine der ersten Vielzahl (3) von Nanofasern und der zweiten Vielzahl (4) von Nanofasern eine Maschendichte aufweist, die so beschaffen ist, dass sie eine erste Vielzahl von Quantenkavitäten definiert, die für eine Wechselwirkung mit der elektromagnetischen Welle mit einer bestimmten Wellenlänge konfiguriert sind.

2. Die Rectenna nach Anspruch 1, wobei die erste Vielzahl (3) von Nanofasern und die zweite Vielzahl (4) von Nanofasern durch ein Elektrospinnverfahren hergestellt sind.

3. Die Rectenna gemäß Anspruch 1 oder 2, wobei die erste Vielzahl von Nanofasern (3) und/oder die zweite Vielzahl von Nanofasern (4) mindestens zwei Untergruppen von Nanofasern umfasst, die entlang jeweiliger Ablagerungsrichtungen ausgerichtete Nanofasern umfassen, wobei die Ablagerungsrichtung jeder Untergruppe von Nanofasern vorzugsweise in Bezug auf die Ablagerungsrichtung mindestens einer anderen Untergruppe von Nanofasern geneigt ist.

4. Die Rectenna gemäß einem der vorstehenden Ansprüche, umfassend eine dritte Vielzahl von Nanofasern, die auf der zweiten Vielzahl (4) von Nanofasern abgeschieden sind und eine Auffangschicht mit einer Maschendichte definieren, die so beschaffen ist, dass sie eine Vielzahl von zweiten Quantenkavitäten definiert, die für eine Wechselwirkung mit der elektromagnetischen Welle mit einer bestimmten Wellenlänge konfiguriert sind.

5. Die Rectenna gemäß einem der vorstehenden Ansprüche, wobei jeder Quantenkavität so ausgelegt ist, dass er ein Atom im Grundzustand zurückhält.

6. Die Rectenna gemäß einem der vorstehenden Ansprüche, wobei das Stützelement (2) und/oder die erste Vielzahl (3) von Nanofasern und/oder die zweite Vielzahl (4) von Nanofasern aus mindestens einem Material hergestellt sind, das ausgewählt ist aus: leitfähigen Materialien, vorzugsweise Polycaprolacton, PCL, A-PCL, Polyanilin, PANI, PANI-3 und Kombinationen davon, strukturell leitfähigen Materialien, vorzugsweise Kohlenstoffnanoröhren, Halbleitermaterialien, vorzugsweise Titandioxid, TiO2, und Zinkoxid, ZnO, oder Eisenoxid und/oder Bornitrid, h-BN.

7. Die Rectenna gemäß einem der vorstehenden Ansprüche, umfassend eine Ausrichtungsbasis (5), wobei das Stützelement (2) drehbar mit der Ausrichtungsbasis (5) gekoppelt ist, um sich um eine in dem plattenförmigen Stützelement (2) liegende Drehachse zu drehen.

8. Vorrichtung zur Energieumwandlung, umfassend:
- mindestens eine Rectenna (1) gemäß Anspruch 7;
- Bewegungsmittel, die mit der mindestens einen Rectenna (1) verbunden und so konfiguriert sind, dass sie das Stützelement (2) durch Ändern der Ausrichtung der ersten und zweiten Vielzahl (3, 4) von Nanofasern drehen;
- eine Steuereinheit (C), die so konfiguriert ist, dass sie ein von der mindestens einen Rectenna (1) erzeugtes Stromsignal misst und die Bewegungseinrichtung in Abhängigkeit von diesem Stromsignal aktiviert.

9. Vorrichtung nach Anspruch 8, wobei die Steuereinheit (C) so konfiguriert ist, dass sie die Bewegungseinrichtung aktiviert, um die mindestens eine Rectenna (1) mit einer elektromagnetischen Welle abzustimmen.

10. Vorrichtung nach einem der Ansprüche 8 bis 9, umfassend eine Vielzahl von Rectennas (1).

11. Vorrichtung nach Anspruch 10, wobei die Steuereinheit (C) so konfiguriert ist, dass sie die Bewegungseinrichtung aktiviert, um jede Rectenna (1) unabhängig und autonom zu drehen.

12. Vorrichtung nach einem der Ansprüche 8 bis 11, umfassend eine Batterie (B), die elektrisch mit der mindestens einen Rectenna (1) verbunden und so konfiguriert ist, dass sie die von der Rectenna (1) umgewandelte elektrische Energie speichert.

## Revendications

1. Rectenna pour convertir de l'énergie, comprenant :
- un élément de support en forme de plaque (2) ;
- une première pluralité (3) de nanofibres électriquement conductrices déposées sur ledit élément de support (2) pour définir un redresseur de courant de la rectenna ;
- une deuxième pluralité (4) de nanofibres électriquement conductrices déposées sur la première pluralité (3) de nanofibres pour définir une antenne de la rectenna configurée pour capter une onde électromagnétique ;
et **caractérisée en ce qu'**au moins l'une de la première pluralité (3) de nanofibres et de la deuxième pluralité (4) de nanofibres a une densité de maillage telle qu'elle définit une première pluralité de cavités quantiques configurées pour une interaction avec l'onde électromagnétique ayant une longueur d'onde spécifique.

2. Rectenna selon la revendication 1, dans laquelle la première pluralité (3) de nanofibres et la deuxième pluralité (4) de nanofibres sont fabriquées par un procédé d'électrofilage.

3. Rectenna selon la revendication 1 ou 2, dans laquelle la première pluralité de nanofibres (3) et/ou la deuxième pluralité de nanofibres (4) comprend au moins deux sous-ensembles de nanofibres comprenant des nanofibres alignées le long de directions de dépôt respectives, la direction de dépôt de chaque sous-ensemble de nanofibres étant de préférence inclinée par rapport à la direction de dépôt d'au moins un sous-ensemble différent de nanofibres.

4. Rectenna selon l'une quelconque des revendications précédentes, comprenant une troisième pluralité de nanofibres, déposées sur la deuxième pluralité (4) de nanofibres, définissant une couche de capture ayant une densité de maillage telle qu'elle définit une pluralité de deuxièmes cavités quantiques configurées pour interagir avec l'onde électromagnétique ayant une longueur d'onde spécifique.

5. Rectenna selon l'une quelconque des revendications précédentes, dans laquelle chaque cavité quantique est adaptée pour retenir un atome dans l'état fondamental.

6. Rectenna selon l'une quelconque des revendications précédentes, dans laquelle l'élément de support (2) et/ou la première pluralité (3) de nanofibres et/ou la deuxième pluralité (4) de nanofibres sont constitués d'au moins un matériau choisi parmi : des matériaux conducteurs, de préférence le polycaprolactone, PCL, A-PCL, la polyaniline, PANI, PANI-3, et leurs combinaisons, des matériaux structurellement conducteurs, de préférence des nanotubes de carbone, des matériaux semi-conducteurs, de préférence du dioxyde de titane, TiO2, et de l'oxyde de zinc, ZnO, ou de l'oxyde ferreux et/ou du nitrure de bore, h-BN.

7. Rectenna selon l'une quelconque des revendications précédentes, comprenant une base d'orientation (5), ledit élément de support (2) étant couplé de manière rotative à la base d'orientation (5) pour tourner autour d'un axe de rotation situé dans ledit élément de support en forme de plaque (2).

8. Dispositif de conversion d'énergie comprenant :
- au moins une rectenna (1) selon la revendication 7 ;
- des moyens de déplacement associés à ladite au moins une rectenna (1) et configurés pour faire tourner l'élément de support (2) en modifiant l'orientation de la première et de la deuxième pluralité (3, 4) de nanofibres
- une unité de commande (C) configurée pour mesurer un signal de courant généré par ladite au moins une rectenna (1) et pour activer les moyens de déplacement en fonction dudit signal de courant.

9. Dispositif selon la revendication 8, dans lequel l'unité de commande (C) est configurée pour activer le moyen de déplacement de manière à accorder la au moins une rectenna (1) avec une onde électromagnétique.

10. Le dispositif selon l'une quelconque des revendications 8 à 9, comprenant une pluralité de rectennas (1).

11. Dispositif selon la revendication 10, dans lequel l'unité de commande (C) est configurée pour activer les moyens de déplacement de manière à faire tourner chaque rectenna (1) de manière indépendante et autonome.

12. Le dispositif selon l'une quelconque des revendications 8 à 11 comprend une batterie (B) connectée électriquement à la au moins une rectenna (1) et configurée pour stocker l'énergie électrique convertie par ladite rectenna (1).
